# EUROPEAN PATENT SPECIFICATION

(11) **EP 3 346 536 B1**
(45) Date of publication and mention of the grant of the patent: **18.03.2020**
(21) Application number: 16840444.0
(22) Date of filing: 02.09.2016
(51) Int. Cl.: H01M 8/12, H01M 8/24, H01M 8/04298, H01M 8/0637, H01M 8/2425, H01M 8/0217, H01M 8/0432, H01M 8/0444, H01M 8/04701, H01M 8/0215, H01M 8/14, H01M 8/2475

(54) **TEST SYSTEM FOR MULTI-FUEL HIGH TEMPERATURE OPERATING FUEL CELLS, WHICH ALLOWS DIRECT USE OF CARBON- BASED FUELS WITHOUT PROMOTING CARBON DEPOSITION IN FUEL PASSAGE ELEMENTS**
TESTSYSTEM VON MIT MEHREREN BRENNSTOFFEN BETREIBBAREN HOCHTEMPERATUR-BRENNSTOFFZELLEN,WELCHES DIE DIREKTNUTZUNG VON KOHLENSTOFFBASIERTEN BRENNSTOFFEN OHNE VERURSACHUNG VON KOHLENSTOFFABLAGERUNGEN IN BRENNSTOFFLEITUNGEN ERLAUBT
SYSTÈME DE TEST POUR PILES À COMBUSTIBLE À HAUTE TEMPÉRATURE OPÉRANT AVEC PLUSIEURS COMBUSTIBLES QUI PERMET L'ULTILISATION DIRECTE DE COMBUSTIBLES À BASE DE CARBONE SANS RISQUE DE DÉPÔT DE CARBONE DANS DES CONDUITS À COMBUSTIBLE.

(30) Priority: 04.09.2015 BR 102015021820
(43) Date of publication of application: 11.07.2018
(73) Proprietor: Instituto Alberto Luiz Coimbra De Pós Graduação E Pesquisa De Engenharia-COPPE/UFRJ, 21945-970 Rio de Janeiro - RJ (BR); Oxiteno S.A. Industria e Comercio, 01317-001 Sao Paulo - SP (BR); Energiah Participações E Negócios Ltda., 22631-004 Rio de Janeiro - RJ (BR)
(72) Inventor: MIRANDA, Paulo Emílio, Valadão, 22280-030 Rio de Janeiro - RJ (BR); ICARDI, Ugo, Andrea, 22011-010 Rio de Janeiro - RJ (BR)
(74) Representative: Maiwald Patent- und Rechtsanwaltsgesellschaft mbH
(86) International application number: PCT/BR2016/050216
(87) International publication number: WO 2017/035621

(56) References cited:
- EP-A1- 2 330 672
- WO-A1-2015/098453
- US-A- 4 459 340
- US-A1- 2002 076 603
- US-A1- 2002 098 401
- US-A1- 2005 170 234
- US-A1- 2011 183 233
- EGUCHI, T; ET AL.: 'Electrical properties of ceria-based oxides and their application to solid oxide fuel cells' SOLID STATE LONICS vol. 52, no. 1-3, May 1992, NORTH-HOLLAND, pages 165 - 172, XP025754221

## Description

### TECHNICAL FIELD

The present invention relates to the specific design of a laboratory system for testing fuel cells and top plate for closure, interconnection device and base plate for supporting stack of high-temperature multi-fuel operation fuel cells operating in a range between 600 and 1000°C, such as solid-oxide fuel cells and molten-carbonate fuel cells, and utilization methodology with regard to the control of the residence time of the fuel in the reaction chamber, with the special characteristic of allowing the direct use, without previous reform, of a wide range of fuels, even those rich in carbon and administered to the cell in an dehydrated state, in such a way that carbon deposition in the system or devices does not occur or is limited.

### DESCRIPTION OF THE STATE OF THE ART

The present invention relates, as a whole, to high-temperature fuel cell systems operating in the range of 600 to 1000 ° C. Fuel cells are electrochemical systems that directly convert the chemical energy stored in the fuel into electrical energy and heat, with no burning reaction and high energy efficiency, or can be used as a reactor for the electrochemical conversion of carbon-based fuels into specific hydrocarbons, for example to carry out the oxidative electrochemical coupling of methane into C2 hydrocarbons, such as ethylene and ethane. High-temperature fuel cells may be, for example: solid-oxide fuel cells and molten-carbonate fuel cells. These fuel cells may work by flow of either hydrogen or carbon-based fuel, such as hydrocarbons, including alcohols, provided that internal reform or external pre-reform of the fuel cell is carried out. In these types of systems, the flow of oxidizing gas (usually air or oxygen), either dry or moist, feeds the cathode region of the fuel cell, while the fuel flow feeds the anode region, with possible addition of water in the form of vapor and/or oxygen and/or carbon dioxide. High-temperature cells work between about 600 and 1000°C.

Depending on the type of electrolyte used, at these temperatures there are two possible configurations. In a configuration for oxygen-ion conducting electrolyte, the transport of these ions occurs from the cathode, where the oxidizing gas is admitted, which ionizes and diffuses through the electrolyte, to the anode, where the fuel is admitted and where the oxygen ions react with the fuel, producing electrical energy, heat, water molecules and carbon-rich gases. In another configuration for hydrogen-ion conducing electrolyte, the transport of these ions occurs from the anode, where the fuel is admitted, which reacts to produce hydrogen ions that diffuses through the electrolyte, to the cathode, where the oxidizing gas is admitted and where the hydrogen ions react with the oxidant, producing electrical energy, heat and water molecules. These reactions produce electrons, which, through an external circuit, circulate from the anode to the cathode, generating electricity by the production of electric current. In the case of the use of carbon-based fuel, including anhydrous one, at high temperature, it is usually possible to produce carbon in the reactor or in the stack because of the pyrolysis of the fuel, which may gradually fill the tubes or the gas flow channels of the feeding devices of the fuel cell anode. The present invention aims to drastically resolve or decrease carbon production during high-temperature operation of the fuel cell operating with a flow of carbon-based, also anhydrous, fuel.

In systems for producing electric energy by high-temperature fuel cell, operating in a range of 600 to 1000°C, the fuel cell anode is normally fed into a fuel stream, which may be dry or wet hydrogen or carbon-based fuels to which steam and/or oxygen and/or carbon dioxide may be added.

In the case of direct feed of dry hydrogen or steam, there are no chemical reactions in the gas flow feed devices to the anode, where electrochemical reactions occur.

When carbon-based fuel is used in a fuel cell, pre-reform of this fuel is usually carried out to produce gas rich in hydrogen and carbon monoxide. In this case, the fuel flow reaching the anode compartment is composed of at least hydrogen, carbon monoxide and water. The presence of water in the anodic compartment of the fuel cell also contributes to improve its operation, as it ensures better physico-chemical stability.

In another configuration, carbon-based fuel is used through its direct admission to the fuel cell, without carrying out any pre-reform, but rather by performing internal reform of the fuel cell directly into its anode, using steam and/or oxygen and/or carbon dioxide.

In a special configuration which provides for the use of carbon-based fuel, including anhydrous one, at temperatures in the range of 600 to 1000 °C, there is a high likelihood of formation and deposition of solid carbon in the fuel intake system up to the fuel cell anode compartment, in itself and in the reaction gas outlet ducts, due to the occurrence of pyrolysis reactions. If such a problem is not solved, the deposited carbon may partially or fully fill the feeding device of the fuel cell anode compartment, making it difficult or even preventing the transport of the fuel and even damaging and degrading the anode.

An attempt to solve the aforementioned problem of formation and deposition of carbon in a test system for button cells from the pyrolysis of carbon-based fuel directly admitted to a solid oxide fuel cell has been described in patent CN200810119204A. This invention relates to solving such problem by using a water cooling system in the fuel path up to the anode of the fuel cell, since at the low temperature obtained with such cooling the pyrolysis of the fuel is not favored. This invention provides a solution to the above-mentioned problem only in the case of button cell tests.

Invention US13525663A shows a method for optimizing the amounts of fuel gases to the fuel cell, but always with the use of steam added to the fuel flow, without evaluating the possibility of using anhydrous fuel. This invention aims to optimize system control for different operating conditions.

Invention JP2002104033A solved the problem related to the presence of impurities in the gas flow which is fed to the fuel cell by means of a fuel purification system. The invention provides an interesting solution for eliminating impurities already present in the fuel. However, the case of formation and deposition of carbon due to the use of carbon-base fuels, including anhydrous ones, at high temperature is a different problem. In this case, although the gas flow is already clean and does not contain such impurities, it can generate and deposit solid carbon in the fuel cell anode access devices, in the flow channels and in the reaction gas outlet ducts.

Another invention addressing the problem of impurities in carbonaceous gas streams for fuel cell feed is JP2008229144A, in which the focus is the elimination of odorants present in fuels.

Invention JP2004121535A discloses the solution to the problem of the presence of impurities in exhaust gases, without, however, addressing the issue of the production of solid carbon by pyrolysis.

Invention JP200650176A very interestingly explains a method of production of metallic interconnector for fuel cells but does not solve the case of use of anhydrous carbon-base fuels that can produce solid carbon when they are in contact with metals at high temperatures.

Invention JP201013817A proposes a system to reduce the deterioration of fuel cell electrodes using a special manufacturing technique, but also in this case the problem of production and deposition of carbon with the direct use of carbon base fuels is not solved.

Different methodologies and equipment for the detection of carbon monoxide are shown in inventions US2003387004A, DE19780491A, JP1997537921A and DE19780491T. However, the issue of carbon production and deposition with the direct use of carbon-base fuels at elevated temperatures is not addressed and there are no solutions to this problem.

A device for thermal simulation of the operation of solid oxide fuel cells is disclosed in invention EP2005112297A without, also in this case, addressing the problem of the production and deposition of carbon with the direct use of carbon-base fuels at high temperatures.

The present invention makes possible the direct use of carbon-base fuels, including anhydrous ones, in solid-oxide fuel cells, especially those made with the features disclosed in patents PI0901921-9, PI0803895-3, PI0601210-8, as they relate to methods and types of anode materials that have resistance to coking and pore clogging by the generation and deposition of solid carbon.

### OBJECTIVES OF THE INVENTION

The present invention aims to disclose innovations relating to a performance testing reactor for producing electricity or for the electrochemical conversion of single cell hydrocarbons, the mode suitable for their assembly interconnected with other devices of the system and also interconnection device, plate top for closure and base plate for high-temperature multi-fuel cell stack support, considering operation at high temperatures in a range between 600 and 1000°C and the laboratory system operating mode for testing performance of single and stack cells, and methodology of use with regard to the control of the residence time of the fuel in the reaction chamber, allowing the direct use of carbon-base fuels, including anhydrous ones, without the requirement of carrying out previous reform, guaranteeing the continuous operation of the system without the obstruction with solid carbon deposition of the access routes of the fuel to the fuel cell and the exit of the reaction gases.

### SUMMARY OF THE INVENTION

In order to achieve the objects detailed herein, the present invention will discriminate specificities relating to parts of laboratory system for performance tests of single and stack cell for producing electricity or for the electrochemical conversion of hydrocarbons, as well as relating to interconnection system, top plate for closure and base plate for supporting the stacking of single cells, and methodology of use with regard to the control of residence time of the fuel in the reaction chamber. This set is comprised of a gas feeding and exhaustion system, which promotes controlled feeding of fuel and oxidant, as well as the exhaustion of the reaction product gases, including devices such as flow controllers, valves, pressure transducers and pipes.

In this case, the use of pressure transducers is useful to identify in real time the occurrence of some uncontrolled direct intake of carbon-base fuels that has generated the deposition of solid carbon in the fuel cell access routes, in the fuel distribution channels in the anode and the output of the reaction gases, with partial obstruction, making possible to make decision on methodologies of cleaning and process control. These devices are also useful for real-time identification of issues related to the occurrence of gas leaks, both fuel and oxidant, as well as related to fuel cell rupture, which results in improper connection between the anode and cathode compartments of the fuel cell.

The performance laboratory test system for electricity production or for the electrochemical conversion of hydrocarbons and the interconnection system, with top plate for closure and base plate for supporting the stacking of single cells in short stack configuration, use a reactor with heating system. This reactor is made of specific material necessary to guarantee the non-deposition of carbon with the direct use of carbon-base fuels, including anhydrous ones.

In addition, the reactor for the performance laboratory testing system for electricity production or electrochemical conversion of hydrocarbons, interconnection plates, top plate for closure and base plate for supporting the stacking of single cells, have specific configuration of channels to allow adequate distribution of gases, fuel or oxidant, to the fuel cell electrodes.

In a specific configuration, the material used for the manufacture of the reactor, the interconnection plates, the top plate for closure, and the base plate for supporting said stack ensuring non-deposition of solid carbon, even when operating with carbon-base fuel, inclusive anhydrous one, at high temperatures in the range of 600 to 1000 °C, is made of zirconium oxide or cerium oxide-based material doped with one or more of the oxides yttria, scandia, calcia, gadolinia, samaria, alumina and cobaltite, with total amount of dopants up to 20% by weight.

In the embodiments of the present invention in which laboratory tests of performance of single-fuel cells or short stacks for electricity production or for the electrochemical conversion of hydrocarbons are carried out, which do not produce, by electrochemical reactions, the required amount of heat to ensure the maintenance of the operating temperature in the range between 600 and 1000 ° C, a special heating, control and temperature monitoring system is used, which allows easy and optimized assembly of the devices described in this invention with their specific characteristics, while still guaranteeing the operation control.

The correct functioning of either the laboratory performance test system for single fuel cells or stacks for electricity production or for the electrochemical conversion of hydrocarbons or the actual operation of self-sufficient stacks in heat depends on the use of conventional systems for operation of fuel cells. In the embodiments disclosed in the present invention, these conventional systems required specific development actions for adaptation to the use relating to computational programs of operation and control. They include electrical measurement system using electronic charging device, as well as system for data control, management and storage, operation safety and interconnection with other systems of use of the generated electric energy.

In short, the present invention shows the possibility of direct use of carbon-base fuels, including anhydrous ones, in fuel cells of high operating temperature, with drastic reduction or elimination of any carbon deposition in the fuel inlet ducts, in the flow channels of the fuel cell anode and in the reaction gas outlet ducts. This is accomplished by manufacturing a well-configured fuel cell test system using flow control of the fuel admitted to the anode and using specific material for manufacturing the base, top and stack interconnection plates resistant to coking.

Both the mentioned control factors and the geometric configuration of the devices in the heated regions of the test system influence the residence time of the fuel in the mentioned regions. Such residence time along with the materials selected for the manufacture of the devices in the heated regions of the test system determine the possibility of drastic reduction or elimination of eventual carbon deposition in the fuel inlet ducts, in the anode fuel cell and in the reaction gas outlet ducts.

### DESCRIPTION OF THE FIGURES

The present invention will now be described with reference to a preferred embodiment shown in the attached drawings, of which:

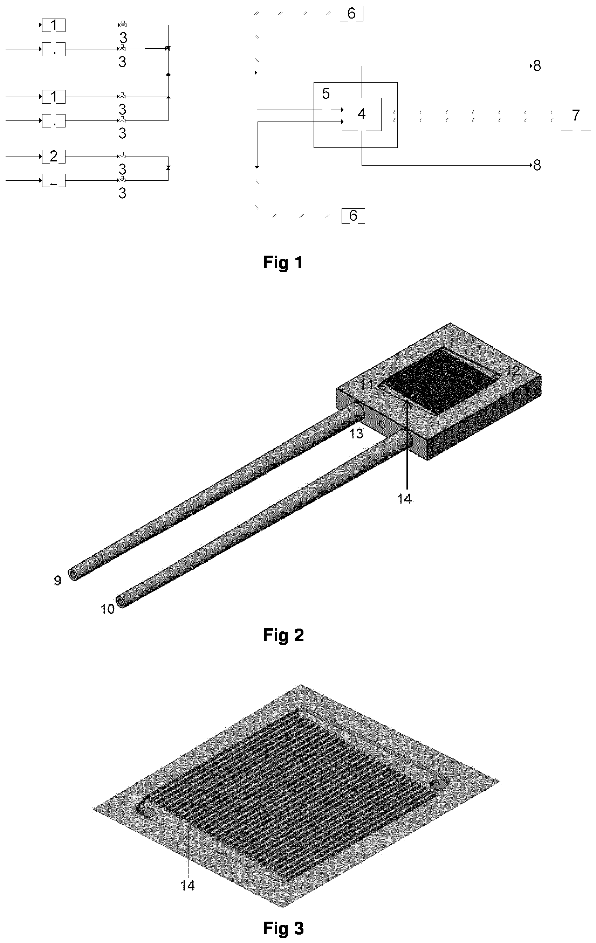

Figure 1: schematic representation of the laboratory test system for high-temperature fuel cells.
Figure 1 illustrates six gas flow controllers, four anode gas controllers 1 and two cathode gas controllers 2. It further illustrates the one-way flow valves 3, the reactor 4 and the furnace 5, two pressure transducers 6, the electric charge 7 and the end of the exhaust gas lines 8.
Figure 2: example of drawing of the half of a reactor for stack fuel cell or the base plate or top plate of a stack. A complete reactor is formed by two equal halves between which there will be either a single cell or a stack, consisting of several single cells separated by interconnection plates.
Figure 2 illustrates the inlet 9 and the outlet 10 of gases in the feeding pipes of a half of the reactor and the inlet 11 and the outlet 12 of gases in the flow channels of a half of the reactor, as well as the inlet of the thermocouple 13 and the flow channels 14.
Figure 3: Example of drawing of the channels for gas passages (detail of a part of a half of the reactor). Figure 3 illustrates an enlargement of the flow channels 14.

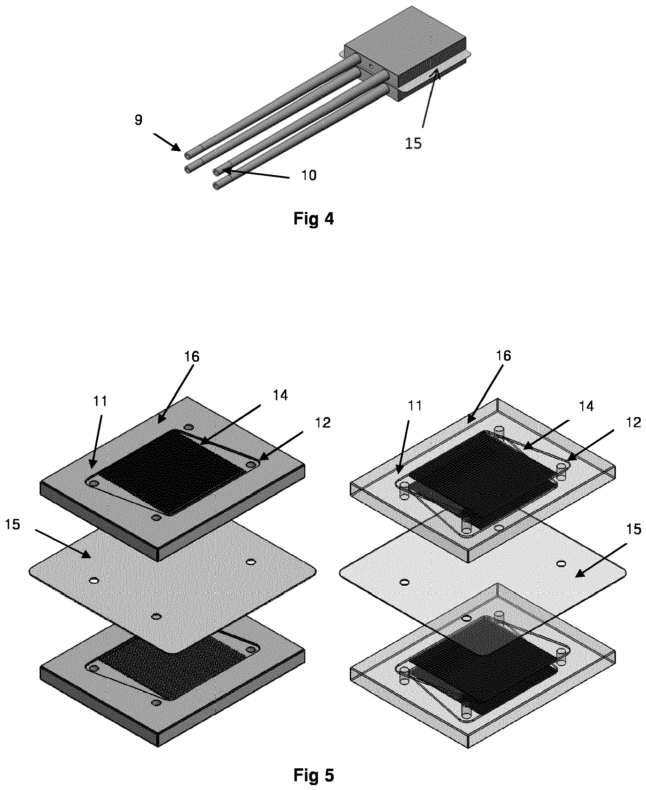

Figure 4: example of drawing of the complete fuel cell reactor, mounted with fuel cell 15 positioned between each halves of the reactor 4.
Figure 5: example of drawing of two interconnection plates for the stack 16, containing a cell between them. The interconnecting plates differ from the base and top plates by having flow channels on both sides.
Figure 5 shows 2 interconnection plates 16 with a stack positioned between them. The left side of the figure shows a three-dimensional drawing and the right side of the figure shows the same drawing, but in transparency, so that the pipes and the gas passageways can be visualized on the interconnection plates.

### DETAILED DESCRIPTION OF THE INVENTION

To achieve the objectives detailed herein, the present invention will discriminate specificities relating to parts of the laboratory system. These relate to parts of laboratory system for performance tests of single and stack cell for producing electricity or for the electrochemical conversion of hydrocarbons, those relating to the interconnection system, top plate for closure and base plate for stack support, and methodology of use about the control of residence time of the fuel in the reaction chamber.

The laboratory test system for test performance on single and stack cell for electricity production or for the electrochemical conversion of hydrocarbons targets performance tests of fuel cells fed with various fuels, including hydrogen, methane, ethanol or other hydrocarbons on the anodic side, and oxygen or air on the cathodic side. Feeding on the oxidant side can be carried out with gases such as oxygen or air, there being also the possibility of operating with or without injection of steam on both sides, in the anode or the cathode of the fuel cell. Operating temperature is expected to be between 600 and 1000°C and working pressure close to atmospheric pressure. In the case of the use of carbon-containing fuels, these conditions are likely to lead to the problem of the possible pyrolysis of these fuels.

The present invention aims to solve or drastically reduce this problem, which presents itself as an obstacle to the tests, because the carbon that is formed can clog the fuel and exhaust pipes on the side of the fuel (anode), as well as the flow channels on the anodic side of the reactor. The project must be divided into different subsystems and each of them consists of one or more equipment including gas feeding and exhaustion, heating system for the reactor, electrical measurements and control, management, data storage and security.

### GAS FEEDING AND EXHAUSTION SYSTEM

A necessary condition for the use of such a test bed is to have a gas grid or gas cylinders of all the necessary gases or, when liquid fuels are used, a tank for storage. To feed the reactor where the fuel cell to be tested is to be placed, equipment is required to control and measure gas flows; these devices must feed the reactor either on the cathode side (oxidizing side: oxygen or air) or on the anode side (fuel side: hydrogen, methane, other hydrocarbons or alcohols).

When liquid fuels are used, the use of a pump system, using pump or pressurized flow, is required before the flow controller (e.g. a fuel such as ethanol is liquid at ambient temperature and atmospheric pressure).

Control of the anodic gas flow through the flow controllers 1 is a necessary condition, as is the design of inlet ducts 9 and outlet 10 and flow channels 14 of the reactor 4, to achieve a residence time of the fuel in the inside the system at a high temperature to prevent the formation of solid carbon. Thus, essential elements of this invention are the material used for the manufacture of components and the control of the residence time of the fuel in the heated regions of the system through the specific design of the components and the control of the flow of the combustible gases.

Moreover, the possibility of feeding inert gas on both sides, anodic and cathodic, is required. For example, nitrogen can be used to clean the system prior to testing as well as to ensure safety against explosion or combustion on the fuel side.

Explosion or combustion may occur a condition in which the system, when switched off, admits the input of air into the reactor and, when at high temperature with fuel injection, the fuel-to-air ratio reaches a percentage capable of triggering spontaneous combustion. Therefore, it is necessary to remove any air present in the anode compartment using a nitrogen flow before supplying the flammable combustible gases.

When anodic feeding occurs with anhydrous carbon-base fuels, it is necessary to evaluate, with the aid of an external measurement, the possibility of carbon formation arising from the occurrence of pyrolysis of the combustible gas at high operating temperature, which results in system clogging. One way of detecting such a problem is by measuring the pressure before the fuel flow in the reactor. This measurement is carried out, for example, using pressure transducers. Pressure transducers may also be a means to evaluate problems of fuel cell rupture or leakage of gases out of the reactor. When the fuel cell ruptures, the anodic and cathodic flows can mix, resulting in a variation in the pressure of the anodic or cathodic lines.

In case of carbon formation, as described above, safeguarded the safety conditions, oxygen is fed on the anodic side, to promote its reaction with the carbon formed by pyrolysis, resulting in the production of carbon oxides and consequent cleaning of the reactor. Exhaust gases at high temperature at the exit of the reactor must be conducted to an appropriate exhaust system to prevent any chance of unsafe environment from occurring. Figure 1 shows the complete system design.

The left part of Figure 1 illustrates six gas flow controllers 1, 2. Such controllers shown in Figure 1 are provided for four possible anode gases introduced into the system by flow controllers 1 and two possible cathode gases introduced into the system by flow controllers 2. After the gases flow through the controllers 1,2 and through the one-way flow valves 3, they feed the reactor 4, which is positioned in the furnace 5. Before the reactor, the two pressure transducers 6 are visible. The right side of Figure 1 illustrates the electric charge 7 and the termination of the lines of the exhaust gases 8. The whole assembly is positioned on a hood with exhaust system to eliminate the exhaust gases and any other gases resulting from leaks, which are potentially dangerous.

### REACTOR WITH HEATING SYSTEM

The gases, fuel and oxidant, are regulated with suitable flows to flow in the reactor 4. However, high-temperature fuel cells operate at temperatures which may require heating system 5 of reactor 4 with an operating temperature holding capacity of at least up to 1000 ° C The use of a system heating ramp suitable for the type of fuel cell used to prevent differential thermal expansion of its different components from damaging the fuel cell is necessary. This is the reason why, for example, heating ramps with slow rates, less than 1°C per minute, are used. The guarantee of mechanical compatibility of the fuel cell is facilitated using materials with similar coefficients of thermal expansion. Thus, the reactor consists of materials with coefficient of thermal expansion similar to the cell material and the sealing material.

When carbon-base fuels are used, including anhydrous ones, the material of the reactor can cause the problem of favoring carbon formation. In fact, reactors for planar solid oxide fuel cell (SOFC) tests are usually made of steel, for example, with ferritic stainless steel called CROFER, a material that catalyzes the pyrolysis of carbon-base fuel, including anhydrous fuel, fed to the reactor 4, causing the production of high amounts of solid carbon already in its feeding pipes.

In order to either solve or reduce the problem of solid carbon formation in the high temperature regions of the system, that is, which reach thermodynamically-favorable pyrolysis reaction conditions for the fuel used, the reactor material 4 used must have specific characteristics, such as not to catalyze the pyrolysis of the fuel fed into the anode compartment at the operating temperature and to have a mechanical strength and coefficient of thermal expansion adequate to the operating conditions and the component materials of SOFC. To solve this problem, a reactor 4 made of a zirconia or ceria-based material was designed. In a specific configuration, zirconium oxide or cerium oxide-based material doped with one or more of the oxides of yttria, scandia, calcia, gadolinia, samaria, alumina and cobaltite was used, with a total amount of dopants up to 20% by weight.

Furthermore, special care was also taken in relation to the reactor project 4. In this case, mathematical simulations were performed to evaluate the gas velocity distribution in the flow channels 14 in the reactor 4 with the aim of properly directing the fuel distribution in the anode, also guaranteeing the required high temperature mechanical resistance of the material used in the reactor body 4. The convergence in optimized results in these simulations made possible the manufacturing design of the ceramic reactor 4 specially manufactured for use in tests of SOFC.

The drawing of an example of a half of the designed and built reactor 4 is shown in Figure 2. The other half (to form the complete reactor) is the same, and in the fuel cell assembly, the two reactor halves are placed one above the other, the fuel cell being between them (Figure 4).

Figure 2 illustrates the inlet 9 and outlet 10 pipes of the feeding gases from one of the reactor halves converging in the inlet 11 and outlet 12 of the flow channels 14, where the gas comes into contact with the fuel cell 15. Figure 2 also shows the inlet of the thermocouple 13 for measuring the temperature of the reactor 4 in a centralized half-thickness position, up to half the length of the flow channels 14

Figure 3 illustrates an enlargement of the flow channels 14. Figure 4 illustrates the complete reactor 4, showing a fuel cell 15 between the two halves of the reactor 4. A sealing element, for example mica, is used between the reactor halves 4 and the fuel cell 15.

### ELECTRIC MEASURE SYSTEM

In order to evaluate the electric performance of the fuel cells, an equipment that can apply the desired electric charge and measure the voltage and electric current produced by the fuel cell is necessary. The equipment normally used in fuel cell (FC) tests is called electronic charge 7: it is a device that uses electronic components capable of continuously vary the charge, that is, the electric current, over a given interval, making measurement of the electrical variables at the same time. The electronic load 7 can then regulate the resistance of the FC charge circuit to obtain different measurement points, characterized as current and voltage. The control of the device and the storage of the data are made through a serial communication, which uses the protocol RS232.

### ANODE OUTPUT GAS ANALYSIS SYSTEM

When a fuel cell for the electrochemical conversion of hydrocarbons is used, it is necessary to perform analysis of the anode output gases to evaluate the conversion reaction yield in the final products. Such analysis can be carried out by gas chromatography or by using mass analyzer.

### SYSTEM FOR DATA CONTROL, MANAGEMENT, STORAGE, AND SAFETY

In order to manage all of the various devices described above, a hardware-software system is required which, through a computer capable of reading the software instructions, can control and act on each device, to optimize the tests and store the data, which can then be analyzed to evaluate the performance of each fuel cell tested. The software should also be able to control the safety system of the test bench, which together with the laboratory safety system must act to keep the test environment safe. The mentioned software was specially developed for the test bench described herein. Therefore, when the software or instruction set is executed by a computer, the computer will control and trigger the devices of the test system in the desired way.

Such a choice of program or software has been taken to be able to freely control all aspects of the system without limiting future possibilities for modifications or improvements in the process of control and management of the tests, storage of the results and safety management of the test bench.

The interconnecting plates, the top plate for closure, and the base plate for supporting a stack of fuel cells utilize the same technology as the above-described reactor to prevent or decrease carbon formation in the stack environment Figure 2 illustrates an example of base plate (or top plate) for stacking.

Figure 5 shows two interconnection plates with a fuel cell between them. The left side of the figure shows a three-dimensional drawing of a stack interconnecting plates, and the right side of the figure shows the same drawing, but transparent, to show the holes and gas passageways in the plates. As shown, gas passage can only occur through the flow channels positioned on the same side where the gas conducting hole emerges. The plates are designed to let the combustible gas flow on the anode side and let the oxidizing gas flow on the cathodic side, with no possibility of mixing.

The material used to build the reactor 4 is the same as the one used in the manufacture of the interconnecting plates, the top plate for closure, the base plate for stack support, and also for the pipes feeding gases to the stack, consisting of a zirconium oxide or cerium oxide-based material doped with one or more of the oxides, yttria, scandia, calcia, gadolinia, samaria, alumina and cobaltite oxide, with a total amount of dopants up to 20% by weight. A complete stack is made up of overlapping fuel cells and interconnecting plates, further including top plate for closure and base plate for stack support. The top and base plates used at the ends of the stack have flow channels only on the inner side, which is in contact with a fuel cell.

The present invention allows the elimination or drastic reduction of carbon formation in the case of anodic feed carried out with carbonaceous fuels, including anhydrous. This drastic elimination or reduction of carbon formation can be achieved with the following essential elements:
1) The material used in the construction of the reactor 4 (and interconnection plates, top plate for closure and base plate for stack support) is not a pyrolysis catalyst for carbon-base fuel, including anhydrous ones, at high temperature in the high temperature regions of the system, that is to say, which attain conditions of thermodynamically-favorable pyrolysis reaction conditions for the fuel used; and
2) control of the residence time of the combustible gas in the heated regions of the system is done by controlling the flow of gases and the specific design of the components. The amount of solid carbon possibly produced is a function of the reaction rate of the thermal pyrolysis of the fuel at the operating temperature and the residence time of the fuel in the heated regions of the system. As the temperature rises, the reaction rate increases and, therefore, to hinder the eventual production of carbon by pyrolysis, the residence time of the fuel is reduced in the heated regions of the system. The design of the pipes and channels takes into account this residence time of the feeding gas, having to be such that it should not allow the production of carbon, but rather, the reaction of production of electric energy and/or the electrochemical conversion of hydrocarbons. In order to have a low fuel residence time with the use of specific working flow, the section of the fuel feed duct, the access holes to the flow channels and the geometry thereof, must be optimized to avoid or limit possible deposition of carbon by pyrolysis.

The use, in this case, of ceramic material for the manufacture of the reactor, which does not catalyze the fuel pyrolysis reaction, contributes to limit the formation of solid carbon in the access tubes and in the fuel cell environment. Moreover, the control exercised in such a way as to reduce the fuel residence time in the high temperature environments of the system, through control of the fuel flow, limits the occurrence of pyrolysis of the fuel although it is thermodynamically favorable, but with low kinetics of occurrence.

## Claims

1. A test system for multi-fuel high-temperature operating fuel cells, which allows the direct use of carbon-base fuels, including anhydrous ones, without promoting or limiting carbon deposition in the gas inlet and outlet ducts, as well as in the flow channels anode, said system comprising:
a furnace (5) containing a reactor (4), the reactor consisting of at least two interconnection plates and at least one fuel cell (15) located between two interconnection plates, wherein one of the interconnection plates, in contact with a cell, is a cathode side, which receives oxidizing gas, and the other interconnection plate, in contact with said fuel cell, is an anodic side, which receives combustible gas;
The system is **characterized in that** it further comprises:
a controlled gas feeding and exhaustion means connected to the reactor (4);
wherein each plate further comprises a plurality of flow channels (14) on its upper and lower surface, wherein the oxidizing gas and the combustible gas pass through the flow channels (14) to contact the electrodes of the fuel cell (15); and
wherein the top and interconnection base plates are made of a zirconium oxide or cerium oxide-based material doped with one or more of the oxides of yttria, scandia, calcia, gadolinia, samaria, alumina and cobaltite was used, with a total amount of dopants up to 20% by weight.

2. The system, according to claim 1, **characterized in that** the plates and the cells are stacked one above the other in an interleaved manner, and the plates in the uppermost and lowermost positions have flow channels only on their inner surface.

3. The system, according to claim 1 or 2, **characterized in that** the gas-controlled feeding and exhaustion means comprises at least two flow controllers (1, 2).

4. The system, according to any one of claims 1 to 3, **characterized in that** the controlled gas feeding and exhaustion means comprises an inlet pipe with a gas inlet (9) terminating at the inlet (11) of the flow channel (14) of the reactor plate, and an outlet pipe (10) with a gas outlet terminating in the outlet (12) of the flow channel (14) of the reactor plate, wherein both pipes are directed to exhaust gas lines to an exhaust system (8).

5. The system, according to any one of claims 1 to 4, **characterized in that** it further comprises a plurality of one-way valves (3) connected downstream of the flow controllers (1, 2).

6. The system, according to any one of claims 1 to 5, **characterized in that** it comprises four anode gas flow controllers (1) and two cathode gas flow controllers (2)

7. The system, according to any one of claims 1 to 6, **characterized in that** it further comprises an electronic device for varying the electric current of the system continuously, the electronic load (7), during a given test interval.

8. The system, according to any one of claims 1 to 7, **characterized in that** it further comprises a controller device for controlling and activating the devices of the test system.

9. The system, according to any one of claims 1 to 8, **characterized in that** the controller device consists of a set of computer-readable instructions which, when executed by a computer, cause the computer to control and activate the devices of the test system.

10. The system, according to any one of claims 1 to 9, **characterized in that** the reactor 4 further comprises a thermocouple input (13) for receiving a thermocouple to measure the temperature of the reactor (4) in a centralized half-thickness position.

11. The system according to any one of claims 1 to 10, **characterized in that** the multi-fuel high-temperature operating fuel is in a temperature range between 600 and 1000°C.

12. The system, according to any one of claims 1 to 11, **characterized in that** it further comprises at least a pressure transducer (6) for measuring the pressure in the reactor (4) before the input of fuel flow in the reactor (4).

13. The system, according to any one of claims 1 to 12, **characterized in that** the pressure transducers (6) are further configured to identify the fuel cell leakage or gas leakage out of the reactor (4).

14. The system, according to any one of claims 1 to 13, **characterized in that** it comprises air/oxygen feeding on the anode side of the reactor (4), wherein the oxygen reacts with the carbon to produce carbon oxides and clean the reactor (4).), wherein the produced carbon oxides are conducted to the outlet of the exhaust gas line (8) to be expelled from the system.

15. The system, according to any one of claims 1 to 14, **characterized in that** the furnace (5) heat the reactor (4) at a rate of less than 1°C per minute.

16. The system, according to any one of claims 1 to 15, **characterized in that** it comprises nitrogen feeding on both the anodic and cathodic sides of the reactor (4) to clean the system ducts prior to the reactor operation.

17. The system, according to any one of claims 1 to 16, **characterized in that** the reactor (4) consists of materials with a coefficient of expansion similar to the fuel cell material and the sealing material.

18. The system, according to any one of claims 1 to 17, **characterized in that** the reactor halves (4) and fuel cells (15) are sealed with a sealant.

19. The system, according to anyone of claims 1 to 18, **characterized in that** the sealant is mica.

20. The system, according to any one of claims 1 to 19, **characterized in that** it carries out electrochemical conversion of hydrocarbons, determining the yield by gas chromatography or by using mass analyzer.

## Patentansprüche

1. Testsystem für mit mehreren Brennstoffen betriebene Hochtemperaturbrennstoffzellen, das die Direktnutzung von kohlenstoffbasierten Brennstoffen erlaubt, beinhaltend wasserfreie, ohne Kohlenstoffablagerung in Gaseinlass- und Auslasskanälen wie auch in der Strömungskanalanode zu fördern oder einzuschränken, wobei das System umfasst:
einen Brennofen (5), der einen Reaktor (4) enthält, wobei der Reaktor aus mindestens zwei Verbindungsplatten und mindestens einer Brennstoffzelle (15), die zwischen zwei Verbindungsplatten liegt, besteht, wobei eine der Verbindungsplatten in Kontakt mit einer Zelle eine Kathodenseite ist, die Oxidationsgas empfängt, und die andere Verbindungsplatte in Kontakt mit der Brennstoffzelle eine anodische Seite ist, die Brenngas empfängt;
das System **dadurch gekennzeichnet ist, dass** es weiter umfasst:
ein gesteuertes Gaszufuhr- und -Abgasmittel, das mit dem Reaktor (4) verbunden ist;
wobei jede Platte weiter eine Vielzahl von Strömungskanälen (14) an ihrer oberen und unteren Fläche umfasst, wobei das Oxidationsgas und das Brenngas durch die Strömungskanäle (14) gehen, um die Elektroden der Brennstoffzelle (15) zu kontaktieren; und
wobei die Deck- und Verbindungsbasisplatten aus einem Zirkonoxid- oder Ceriumoxid-basierten Material hergestellt sind, das unter Verwendung eines oder mehrerer der Oxide von Yttriumoxid, Scandiumoxid, Calciumoxid, Gadoliniumoxid, Samariumoxid, Aluminiumoxid und Cobaltit mit einer Gesamtmenge an Dotierstoffen von bis zu 20 Gewichtsprozent dotiert ist.

2. System nach Anspruch 1, **dadurch gekennzeichnet, dass** die Platten und die Zellen auf eine verschachtelte Weise übereinandergestapelt sind und die Platten in der obersten und untersten Position nur an deren Innenfläche Strömungskanäle aufweisen.

3. System nach Anspruch 1 oder 2, **dadurch gekennzeichnet, dass** das gasgesteuerte Zufuhr- und Abgasmittel mindestens zwei Strömungssteuerungen (1, 2) umfasst.

4. System nach einem der Ansprüche 1 bis 3, **dadurch gekennzeichnet, dass** das gesteuerte Gaszufuhr- und Abgasmittel ein Einlassrohr mit einem Gaseinlass (9), der beim Einlass (11) des Strömungskanals (14) der Reaktorplatte ausläuft, und ein Auslassrohr (10) mit einem Gasauslass, der im Auslass (12) des Strömungskanals (14) der Reaktorplatte ausläuft, umfasst, wobei beide Rohre zu Abgasleitungen zu einem Abgassystem (8) gerichtet sind.

5. System nach einem der Ansprüche 1 bis 4, **dadurch gekennzeichnet, dass** es weiter eine Vielzahl von Einwegventilen (3) umfasst, die stromabwärts der Strömungssteuerungen (1, 2) verbunden sind.

6. System nach einem der Ansprüche 1 bis 5, **dadurch gekennzeichnet, dass** es vier Anodengasströmungssteuerungen (1) und zwei Kathodengasströmungssteuerungen (2) umfasst.

7. System nach einem der Ansprüche 1 bis 6, **dadurch gekennzeichnet, dass** es weiter eine elektronische Vorrichtung zum kontinuierlichen Variieren des elektrischen Stroms des Systems und der elektronischen Last (7) während eines vorgegebenen Testintervalls umfasst.

8. System nach einem der Ansprüche 1 bis 7, **dadurch gekennzeichnet, dass** es weiter eine Steuervorrichtung zum Steuern und Aktivieren der Vorrichtungen des Testsystems umfasst.

9. System nach einem der Ansprüche 1 bis 8, **dadurch gekennzeichnet, dass** die Steuervorrichtung aus einem Satz von rechnerlesbaren Anweisungen besteht, die, wenn von einem Rechner ausgeführt, den Rechner dazu veranlassen, die Vorrichtungen des Testsystems zu steuern und zu aktivieren.

10. System nach einem der Ansprüche 1 bis 9, **dadurch gekennzeichnet, dass** der Reaktor (4) weiter einen Thermoelementeingang (13) zum Aufnehmen eines Thermoelements umfasst, um die Temperatur des Reaktors (4) in einer mittigen Halbdickenposition zu messen.

11. System nach einem der Ansprüche 1 bis 10, **dadurch gekennzeichnet, dass** der Mehrbrennstoff-Hochtemperaturbetriebsbrennstoff in einer Temperaturspanne zwischen 600 und 1000°C ist.

12. System nach einem der Ansprüche 1 bis 11, **dadurch gekennzeichnet, dass** es weiter mindestens einen Druckwandler (6) zum Messen des Drucks im Reaktor (4) vor dem Eingang von Brennstoffströmung in den Reaktor (4) umfasst.

13. System nach einem der Ansprüche 1 bis 12, **dadurch gekennzeichnet, dass** die Druckwandler (6) weiter konfiguriert sind, den Brennstoffzellverlust oder Gasverlust aus dem Reaktor (4) zu identifizieren.

14. System nach einem der Ansprüche 1 bis 13, **dadurch gekennzeichnet, dass** es Luft/Sauerstoff-Zufuhr an der Anodenseite des Reaktors (4) umfasst, wobei der Sauerstoff mit dem Kohlenstoff reagiert, um Kohlenstoffoxide zu erzeugen und den Reaktor (4) zu reinigen, wobei die erzeugten Kohlenstoffoxide zum Auslass der Abgasleitung (8) geleitet werden, um aus dem System ausgestoßen zu werden.

15. System nach einem der Ansprüche 1 bis 14, **dadurch gekennzeichnet, dass** der Brennofen (5) den Reaktor (4) bei einer Rate von weniger als 1°C pro Minute aufheizt.

16. System nach einem der Ansprüche 1 bis 15, **dadurch gekennzeichnet, dass** es Stickstoffzufuhr an sowohl der anodischen als auch kathodischen Seite des Reaktors (4) umfasst, um die Systemkanäle vor dem Reaktorbetrieb zu reinigen.

17. System nach einem der Ansprüche 1 bis 16, **dadurch gekennzeichnet, dass** der Reaktor (4) aus Materialien mit einem Ausdehnungskoeffizienten ähnlich dem Brennstoffzellenmaterial und dem Dichtungsmaterial besteht.

18. System nach einem der Ansprüche 1 bis 17, **dadurch gekennzeichnet, dass** die Reaktorhälften (4) und Brennstoffzellen (15) mit einem Dichtungsmittel abgedichtet sind.

19. System nach einem der Ansprüche 1 bis 18, **dadurch gekennzeichnet, dass** das Dichtungsmittel Glimmer ist.

20. System nach einem der Ansprüche 1 bis 19, **dadurch gekennzeichnet, dass** es elektrochemische Umwandlung von Kohlenwasserstoffen umsetzt, wobei der Ertrag durch Gaschromatographie oder unter Verwendung eines Masseanalysators ermittelt wird.

## Revendications

1. Système de test pour piles à haute température de fonctionnement multi-combustible, qui permet l'utilisation directe de combustibles à base de carbone, y compris des combustibles anhydres, sans favoriser ou limiter un dépôt de carbone dans les conduits d'entrée et de sortie de gaz, ainsi que dans l'anode de canaux d'écoulement, ledit système comprenant :
un four (5) contenant un réacteur (4), le réacteur étant constitué d'au moins deux plaques d'interconnexion et d'au moins une pile à combustible (15) située entre deux plaques d'interconnexion, dans lequel l'une des plaques d'interconnexion, en contact avec une pile, est un côté cathode, qui reçoit du gaz oxydant, et l'autre plaque d'interconnexion, en contact avec ladite pile à combustible, est un côté anodique, qui reçoit du gaz combustible ;
le système est **caractérisé en ce qu'**il comprend en outre :
un moyen d'alimentation et d'échappement de gaz contrôlé raccordé au réacteur (4) ;
dans lequel chaque plaque comprend en outre une pluralité de canaux d'écoulement (14) sur sa surface supérieure et inférieure, dans lequel le gaz oxydant et le gaz combustible passent à travers les canaux d'écoulement (14) pour entrer en contact avec les électrodes de la pile à combustible (15) ; et
dans lequel les plaques de base supérieures et d'interconnexion sont formées avec un matériau à base d'oxyde de zirconium ou d'oxyde de cérium dopé en utilisant un ou plusieurs des oxydes suivants : oxyde d'yttrium, oxyde de scandium, oxyde de calcium, oxyde de gadolinium, oxyde de samarium, alumine et cobaltite, avec un quantité totale de dopants allant jusqu'à 20 % en poids.

2. Système, selon la revendication 1, **caractérisé en ce que** les plaques et les piles sont empilées les unes au-dessus des autres de manière entrelacée, et les plaques dans les positions les plus haute et basse n'ont des canaux d'écoulement que sur leur surface intérieure.

3. Système, selon la revendication 1 ou 2, **caractérisé en ce que** le moyen d'alimentation et d'échappement de gaz contrôlé comprend au moins deux contrôleurs de d'écoulement (1, 2).

4. Système, selon l'une quelconque des revendications 1 à 3, **caractérisé en ce que** le moyen d'alimentation et d'échappement de gaz contrôlé comprend un tuyau d'entrée ayant une entrée de gaz (9) se terminant au niveau de l'entrée (11) du canal d'écoulement (14) de la plaque de réacteur, et un tuyau de sortie (10) ayant une sortie de gaz se terminant dans la sortie (12) du canal d'écoulement (14) de la plaque de réacteur, dans lequel les deux tuyaux sont dirigés vers des conduites de gaz d'échappement dans un système d'échappement (8).

5. Système, selon l'une quelconque des revendications 1 à 4, **caractérisé en ce qu'**il comprend en outre une pluralité de vannes unidirectionnelles (3) connectées en aval des contrôleurs de d'écoulement (1, 2).

6. Système, selon l'une quelconque des revendications 1 à 5, **caractérisé en ce qu'**il comprend quatre contrôleurs d'écoulement de gaz anodique (1) et deux contrôleurs d'écoulement de gaz cathodique (2).

7. Système, selon l'une quelconque des revendications 1 à 6, **caractérisé en ce qu'**il comprend en outre un dispositif électronique pour faire varier en continu le courant électrique du système, la charge électronique (7), pendant un intervalle de test donné.

8. Système, selon l'une quelconque des revendications 1 à 7, **caractérisé en ce qu'**il comprend en outre un dispositif contrôleur pour contrôler et activer les dispositifs du système de test.

9. Système, selon l'une quelconque des revendications 1 à 8, **caractérisé en ce que** le dispositif contrôleur est constitué d'un ensemble d'instructions lisibles par ordinateur qui, lorsqu'elles sont exécutées par un ordinateur, amènent l'ordinateur à contrôler et activer les dispositifs du système de test.

10. Système, selon l'une quelconque des revendications 1 à 9, **caractérisé en ce que** le réacteur (4) comprend en outre une entrée de thermocouple (13) pour recevoir un thermocouple pour mesurer la température du réacteur (4) dans une position à mi-épaisseur centralisée.

11. Système selon l'une quelconque des revendications 1 à 10, **caractérisé en ce que** le combustible à haute température de fonctionnement multi-combustible est dans une plage de température comprise entre 600 et 1 000°C.

12. Système, selon l'une quelconque des revendications 1 à 11, **caractérisé en ce qu'**il comprend en outre au moins un transducteur de pression (6) pour mesurer la pression dans le réacteur (4) avant l'entrée d'écoulement de combustible dans le réacteur (4).

13. Système, selon l'une quelconque des revendications 1 à 12, **caractérisé en ce que** les transducteurs de pression (6) sont en outre configurés pour identifier la fuite de pile à combustible ou la fuite de gaz hors du réacteur (4).

14. Système, selon l'une quelconque des revendications 1 à 13, **caractérisé en ce qu'**il comprend une alimentation en air/oxygène sur le côté anode du réacteur (4), dans lequel l'oxygène réagit avec le carbone pour produire des oxydes de carbone et nettoyer le réacteur (4), dans lequel les oxydes de carbone produits sont conduits jusqu'à la sortie de la conduite de gaz d'échappement (8) pour être expulsés du système.

15. Système, selon l'une quelconque des revendications 1 à 14, **caractérisé en ce que** le four (5) chauffe le réacteur (4) à une vitesse inférieure à 1°C par minute.

16. Système, selon l'une quelconque des revendications 1 à 15, **caractérisé en ce qu'**il comprend de l'azote alimentant à la fois les côtés anodique et cathodique du réacteur (4) pour nettoyer les conduits de système avant le fonctionnement de réacteur.

17. Système, selon l'une quelconque des revendications 1 à 16, **caractérisé en ce que** le réacteur (4) est constitué de matériaux ayant un coefficient de dilatation similaire au matériau de pile à combustible et au matériau d'étanchéité.

18. Système, selon l'une quelconque des revendications 1 à 17, **caractérisé en ce que** les moitiés de réacteur (4) et les piles à combustible (15) sont scellées à l'aide d'un produit d'étanchéité.

19. Système, selon l'une quelconque des revendications 1 à 18, **caractérisé en ce que** le produit d'étanchéité est du mica.

20. Système, selon l'une quelconque des revendications 1 à 19, **caractérisé en ce qu'**il effectue une conversion électrochimique d'hydrocarbures, en déterminant le rendement par chromatographie en phase gazeuse ou en utilisant un analyseur de masse.
